(19) Europäisches Patentamt
European Patent Office
Office européen des brevets

(11) EP 2 853 866 A1

(12) **EUROPEAN PATENT APPLICATION**
published in accordance with Art. 153(4) EPC

(43) Date of publication:
**01.04.2015 Bulletin 2015/14**

(21) Application number: **13789996.9**

(22) Date of filing: **10.05.2013**

(51) Int Cl.:
***G01J 1/02*** *(2006.01)* ***H01L 31/10*** *(2006.01)*

(86) International application number:
**PCT/JP2013/063182**

(87) International publication number:
**WO 2013/172269 (21.11.2013 Gazette 2013/47)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **16.05.2012 JP 2012112348**
**28.12.2012 JP 2012287866**
**11.03.2013 PCT/JP2013/056621**

(71) Applicant: **Hamamatsu Photonics K.K.**
**Hamamatsu-shi, Shizuoka 435-8558 (JP)**

(72) Inventors:
- **NAKAJIMA, Kazutoshi**
**Hamamatsu-shi, Shizuoka 435-8558 (JP)**
- **YAMANISHI, Masamichi**
**Hamamatsu-shi, Shizuoka 435-8558 (JP)**
- **FUJITA, Kazuue**
**Hamamatsu-shi, Shizuoka 435-8558 (JP)**
- **NIIGAKI, Minoru**
**Hamamatsu-shi, Shizuoka 435-8558 (JP)**
- **HIROHATA, Toru**
**Hamamatsu-shi, Shizuoka 435-8558 (JP)**
- **YAMASHITA, Hiroyuki**
**Hamamatsu-shi, Shizuoka 435-8558 (JP)**
- **AKAHORI, Wataru**
**Hamamatsu-shi, Shizuoka 435-8558 (JP)**

(74) Representative: **Hoffmann Eitle**
**Patent- und Rechtsanwälte PartmbB**
**Arabellastraße 30**
**81925 München (DE)**

(54) **PHOTODETECTOR**

(57) A photodetector 1A comprises an optical element 10, having a structure including first regions and second regions periodically arranged with respect to the first regions along a plane perpendicular to a predetermined direction, for generating an electric field component in the predetermined direction when light is incident thereon along the predetermined direction; and a semiconductor multilayer body 4 having a quantum cascade structure, arranged on the other side opposite from one side in the predetermined direction with respect to the optical element, for producing a current according to the electric field component in the predetermined direction generated by the optical element 10; while the quantum cascade structure includes an active region 4b having a first upper quantum level and a second upper quantum level lower than the first upper quantum level, and an injector region 4c for transporting an electron excited by the active region 4b.

*Fig.2*

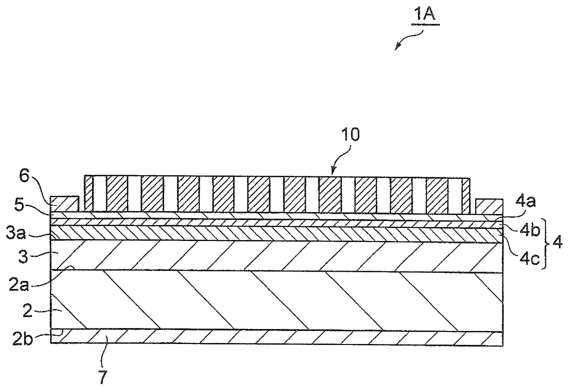


EP 2 853 866 A1

## Description

### Technical Field

The present invention relates to a photodetector.

### Background Art

Known as photodetectors utilizing light absorption of quantum intersubband transitions are QWIP (quantum well type infrared optical sensor), QDIP (quantum dot infrared optical sensor), QCD (quantum cascade type optical sensor), and the like. They utilize no energy bandgap transitions and thus have such merits as high degree of freedom in designing wavelength ranges, relatively low dark current, and operability at room temperature.

Among these photodetectors, the QWIP and QCD are equipped with a semiconductor multilayer body having a periodic multilayer structure such as a quantum well structure or quantum cascade structure. This semiconductor multilayer body generates a current due to an electric field component in the stacking direction thereof only when light incident thereon has such an electric field component, and thus is not photosensitive to light having no electric field component in the stacking direction (planar waves incident thereon in the stacking direction thereof).

Therefore, in order for the QWIP or QCD to detect light, it is necessary for the light to be incident thereon such that a direction of vibration of an electric field of the light coincides with the stacking direction of the semiconductor multilayer body. When detecting a planar wave having a wavefront perpendicular to an advancing direction of light, for example, it is necessary for the light to be incident on the semiconductor multilayer body in a direction perpendicular to its stacking direction, which makes the photodetector cumbersome to use.

There has hence been known a photodetector which, for detecting light having no electric field component in the stacking direction of a semiconductor multilayer body, a thin gold film is disposed on a surface of the semiconductor multilayer body and periodically formed with holes each having a diameter not greater than the wavelength of the light (see Non Patent Literature 1). In this example, the light is modulated so as to attain an electric field component in the stacking direction of the semiconductor multilayer body under a surface plasmonic resonance effect on the thin gold film.

There has also been known a photodetector in which a light-transmitting layer is disposed on a surface of a semiconductor multilayer body, while a diffraction grating constituted by a pattern of irregularities and a reflective film covering the same are formed on a surface of the light-transmitting layer (see Patent Literature 1). In this example, the light is modulated so as to attain an electric field component in the stacking direction of the semiconductor multilayer body under the effects of diffraction and reflection of the incident light by the diffraction grating and reflective film.

A photodetector processed such as to have an entrance surface tilted with respect to the stacking direction of a semiconductor multilayer body has also been known (see Patent Literature 2). In this example, light entering from the entrance surface with refraction repeats total reflection within a chip and thus is modulated so as to have an electric field component in the stacking direction of the semiconductor multilayer body.

While photodetectors utilizing quantum wells inherently have a characteristic that their detectable wavelength band is narrow, it has been known to form a structure having different barrier thicknesses and well widths and heights (see Patent Literature 3) and to stack quantum well layers having different components and take out signals from the respective layers (Non Patent Literature 2), for attempting to realize to widen the wavelength band.

### Citation List

#### Patent Literature

Patent Literature 1: Japanese Patent Application Laid-Open No. 2000-156513
Patent Literature 2: Japanese Patent Application Laid-Open No. 2012-69801
Patent Literature 3: Japanese Translated International Publication No. 2001-524757

#### Non Patent Literature

Non Patent Literature 1: W. Wu, et al., "Plasmonic enhanced quantum well infrared photodetector with high detectivity", Appl. Phys. Lett., 96, 161107 (2010).
Non Patent Literature 2: S. V. Bandara, et al., "Multiband and broad-band infrared detectors based on III-V materials for spectral imaging instruments", Infrared Phys. Technol., 47, 15 (2005).

### Summary of Invention

#### Technical Problem

Thus, for detecting light having no electric field component in the stacking direction of the semiconductor multilayer body, various techniques have been proposed for modulating the light so as to provide it with an electric field component in the stacking direction and widening its wavelength band.

However, the photodetector disclosed in Non Patent Literature 1 has a QWIP structure in which quantum wells having the same well width are simply stacked as its quantum well structure, and a bias voltage must be applied thereto from the outside in order to make it operate as a photodetector, whereby adverse effects of the resulting dark current on photosensitivity cannot be ignored.

For obtaining effective photosensitivity in the photodetector disclosed in Patent Literature 1, on the other hand, quantum well structures must be stacked for many periods, so as to form a number of light-absorbing layers.

In the photodetector disclosed in Patent Literature 2, the propagation direction of light caused by diffraction fails to become completely horizontal, so that only a small part thereof contributes to photoelectric conversion, whereby sufficient photosensitivity may not be obtained.

In the photodetectors disclosed in Patent Literature 3 and Non Patent Literature 2 aimed at attaining wider wavelength bands, quantum well structures which absorb light are distributed from the surface layer to deep layers of the semiconductor multilayer body, whereby light absorption will be less in the deep layers (parts far from the light entrance side) unless electric field components in the stacking direction which are required for photoelectric conversion can be provided uniformly in these layers.

It is therefore an object of the present invention to provide a photodetector which can detect light having no electric field component in the stacking direction of the semiconductor multilayer body, while attaining a widened sensitive wavelength band.

## Solution to Problem

The photodetector of the present invention comprises an optical element, having a structure including first regions and second regions periodically arranged with respect to the first regions along a plane perpendicular to a predetermined direction, for generating an electric field component in the predetermined direction when light is incident thereon along the predetermined direction; and a semiconductor multilayer body having a quantum cascade structure, arranged on the other side opposite from one side in the predetermined direction with respect to the optical element, for producing a current according to the electric field component in the predetermined direction generated by the optical element; while the quantum cascade structure includes an active region having a first upper quantum level and a second upper quantum level lower than the first upper quantum level, and an injector region for transporting an electron excited by the active region.

The optical element in this photodetector generates an electric field component in a predetermined direction when light is incident thereon along the predetermined direction. This electric field component excites an electron in the active region in the quantum cascade structure of the semiconductor multilayer body, and this electron is transported by the injector region, so as to produce a current in the quantum cascade structure. Here, the active region has the first upper quantum level and the second upper quantum level lower than the first upper quantum level, whereby two kinds of wavelengths of light corresponding to respective electronic excitation energies to the upper quantum levels are detected. That is, this photodetector can be said to be able to detect light having no electric field component in the stacking direction of the semiconductor multilayer body, while attaining a widened sensitive wavelength band.

Here, the semiconductor multilayer body may have a plurality of quantum cascade structures stacked along the predetermined direction. This produces a larger current in the semiconductor multilayer body, thereby further raising the photosensitivity of the photodetector.

The photodetector of the present invention may further comprise a first contact layer formed on a surface on the one side of the semiconductor multilayer body and a second contact layer formed on a surface on the other side of the semiconductor multilayer body. In this case, the photodetector of the present invention may further comprise a first electrode electrically connected to the first contact layer and a second electrode electrically connected to the second contact layer. These allow the current produced in the semiconductor multilayer body to be detected efficiently.

The photodetector of the present invention may further comprise a substrate having the second contact layer, semiconductor multilayer body, first contact layer, and optical element stacked thereon successively from the other side. This can stabilize the constituents of the photodetector.

In the optical element in the photodetector of the present invention, the first regions may be constituted by a dielectric body adapted to transmit therethrough light along the predetermined direction and modulate the light or a metal adapted to excite a surface plasmon with the light. Each case can generate an electric field component in the predetermined direction when light is incident on the optical element along the predetermined direction, thereby producing a current in the quantum cascade structure in the semiconductor multilayer body.

In the optical element in the photodetector of the present invention, the period of arrangement of the second regions with respect to the first regions may be 0.5 to 500 μm. This makes it possible to generate the electric field component in the predetermined direction more efficiently when light is incident on the optical element along the predetermined direction.

The light transmitted through the optical element of the present invention may be an infrared ray. This allows the photodetector of the present invention to be used favorably as an infrared photodetector.

In the photodetector of the present invention, the optical element may generate the electric field component in the predetermined direction when light is incident thereon from the one side or through the semiconductor multilayer body from the other side.

**Advantageous Effects of Invention**

The present invention can provide a photodetector which can detect light having no electric field component in the stacking direction of the semiconductor multilayer body, while attaining a widened sensitive wavelength band.

**Brief Description of Drawings**

Fig. 1 is a plan view of a photodetector in accordance with a first embodiment of the present invention;
Fig. 2 is a sectional view taken along the line II-II of Fig. 1;
Fig. 3 is a plan view of an optical element in accordance with the first embodiment of the present invention;
Fig. 4 is a sectional view taken along the line IV-IV of Fig. 3;
Fig. 5 is a diagram illustrating a subband level structure in a quantum cascade structure;
Fig. 6 is a plan view of a modified example of the optical element in accordance with the first embodiment of the present invention;
Fig. 7 is a plan view of a modified example of the optical element in accordance with the first embodiment of the present invention;
Fig. 8 is a sectional view of the photodetector in accordance with a second embodiment of the present invention;
Fig. 9 is a sectional view of the photodetector in accordance with a third embodiment of the present invention;
Fig. 10 is a plan view of the photodetector in accordance with a fourth embodiment of the present invention;
Fig. 11 is a sectional view taken along the line XI-XI of Fig. 10;
Fig. 12 is a plan view of the photodetector in accordance with a fifth embodiment of the present invention;
Fig. 13 is a sectional view taken along the line XIII-XIII of Fig. 12;
Fig. 14 is a plan view of the photodetector in accordance with a sixth embodiment of the present invention;
Fig. 15 is a sectional view taken along the line XV-XV of Fig. 13;
Fig. 16 is an electric field strength distribution according to an FDTD method concerning the optical element of Fig. 8;
Fig. 17 is a graph illustrating photosensitivity spectra for respective numbers of upper quantum levels; and
Fig. 18 is a graph illustrating an integrated value of vertical electric field strength when changing the number of stages of quantum cascade structures.

**Description of Embodiments**

In the following, preferred embodiments of the present invention will be explained in detail with reference to the drawings. The same or equivalent parts in the drawings will be referred to with the same signs, while omitting their overlapping descriptions. The light to be detected by photodetectors (light incident on optical elements) of the embodiments is an infrared ray (light having a wavelength of 1 to 1000 μm).

**First Embodiment**

As illustrated in Figs. 1 and 2, a photodetector 1A comprises a rectangular plate-shaped substrate 2 made of n-type InP having a thickness of 300 to 500 μm and contact layers 3, 5, a semiconductor multilayer body 4, electrodes 6, 7, and an optical element 10 which are stacked thereon. This photodetector 1A is a photodetector which utilizes light absorption of quantum intersubband transitions in the semiconductor multilayer body 4.

The contact layer (second contact layer) 3 is disposed all over a surface 2a of the substrate 2. The semiconductor multilayer body 4 is disposed all over a surface 3a of the contact layer 3. The contact layer (first contact layer) 5 is disposed all over a surface 4a of the semiconductor multilayer body 4. At the center of a surface 5a of the contact layer 5, the optical element 10 having an area smaller than the whole area of the surface 5a is disposed. That is, the optical element 10 is arranged so as to be contained in the contact layer 5 when seen as a plane. In a peripheral region free of the optical element 10 in the surface 5a, the electrode (first electrode) 6 is formed like a ring so as to surround the optical element 10. On the other hand, another electrode (second electrode) 7 is disposed all over a surface 2b of the substrate 2 on the side opposite from the surface 2a of the substrate 2.

The semiconductor multilayer body 4 has a quantum cascade structure designed according to the wavelength of light to be detected, in which an active region 4b adapted to absorb light and excite electrons and an injector region 4c for unidirectionally transporting electrons are formed on top of each other so as to be located on the optical element 10 side and the opposite side, respectively. Here, the quantum cascade structure has a thickness of about 50 nm.

In each of the active and injector regions 4b, 4c, semiconductor layers of InGaAs and InAlAs having respective energy bandgaps different from each other are stacked alternately with a thickness of several nm each. In the active region 4b, the semiconductor layers of InGaAs are doped with n-type impurities such as silicon, so as to function as well layers, while the semiconductor layers of InAlAs alternate with the semiconductor layers of InGaAs and function as barrier layers. In the injector region 4c, on the other hand, semiconductor layers of InGaAs not doped with impurities and those of InAlAs are stacked alternately. The number of stacked layers of InGaAs and InAlAs in the active and injector regions 4b, 4c in total is 16, for example. The structure of the active region 4b determines the center wavelength of light absorbed thereby (as will be explained later in detail).

The contact layers 3, 5, which are made of n-type InGaAs, are respective layers for electrically linking the semiconductor multilayer body 4 to the electrodes 6, 7 in order to detect a current generated in the semiconductor multilayer body 4. Preferably, the contact layer 3 has a thickness of 0.1 to 1 μm. On the other hand, in order to make it easier for effects of the optical element 10 which will be explained later to extend over the quantum cascade structure, it is preferred for the contact layer 5 to be as thin as possible and have a specific thickness of 5 to 100 nm. The electrodes 6, 7 are ohmic electrodes made of Ti/Au.

The optical element 10 generates an electric field component in a predetermined direction when light is incident thereon from one side in the predetermined direction (the side provided with the optical element 10). As illustrated in Figs. 3 and 4, the optical element 10 is equipped with a structure 11, which has first regions R1 and second regions R2 periodically arranged with respect to the first regions R1 along a plane perpendicular to the predetermined direction with a period d which is 0.5 to 500 μm (not longer than the wavelength of the incident light) according to the wavelength of the incident light.

The structure 11 has a film body 13 provided with a plurality of through holes 12 penetrating therethrough from one side to the other side in the predetermined direction. As illustrated in Fig. 3, the plurality of through holes 12 are formed like slits in the film body 13 in a planar view. The slit-shaped through holes 12 are arranged in a row along a direction perpendicular to their longitudinal direction. As illustrated in Fig. 4, each through hole 12 penetrates through the film body 13 from one side to the other side in the predetermined direction (the stacking direction of the semiconductor multilayer body 4 in Fig. 2). Preferably, the film body 13 has a thickness of 10 nm to 2 μm.

Here, the first region R1 is a part 13a between the through holes 12 in the film body 13, which is specifically made of gold. The second region R2 is a space S within the through hole 12, which is specifically an air. That is, when the photodetector 1A is seen as a plane from the photodetector 10 side (i.e., in Fig. 1), a part of the contact layer 5 is seen through the through holes 12.

The quantum cascade structure will now be explained in detail. Fig. 5 is a diagram illustrating a subband level structure in the quantum cascade structure of the photodetector 1A illustrated in Figs. 1 and 2. One quantum cascade structure corresponds to a unit multilayer body 46 constituted by a first barrier layer 171, an absorption well layer 141 used for absorbing incident light, and an extractor structure 48 for relaxing and transporting excited electrons and so forth. Specifically, the quantum cascade structure is constituted by a semiconductor multilayer structure comprising n quantum well layers including a first well layer functioning as an absorption well layer and n quantum barrier layers, where n is an integer of 4 or greater. The extractor structure 48 is constructed by alternately stacking the second to nth barrier layers and second to nth well layers excluding the first barrier layer 171 and absorption well layer 141. In other words, the first barrier layer 171, absorption well layer 141, and second barrier layer form the active region 4b, while the structure subsequent to the second barrier layer corresponds to the injector region 4c.

While the photodetector 1A of this embodiment has only one stage of quantum cascade structure, Fig. 5 illustrates a state where quantum cascade structures are stacked in a plurality of stages. Each of the unit multilayer body 46 is constituted by the first barrier layer 171, the absorption well layer 141 as the first well layer, and the extractor structure 48 successively from the side of the unit multilayer body 46a in the prior stage. Such a configuration forms a subband level structure, which is an energy level structure based on a quantum well structure, in the unit multilayer body 46.

The unit multilayer body 46 in this embodiment has, in its subband level structure, a lower detection level (ground level) $L_{1a}$ and an upper detection level (upper excited level) $L_{1b}$ which are caused by the absorption well layer 141 and second, third, fourth, ..., and nth levels $L_2$, $L_3$, $L_4$, ..., $L_n$ which are caused by the respective well layers of the extractor structure 48 excluding the absorption well layer 141. For example, the second to nth levels $L_2$ to $L_n$ are levels produced as a result of quantum-mechanical combinations caused by the second to nth well layers. Among these energy levels, the lower and upper detection levels $L_{1a}$, $L_{1b}$ are levels concerning light absorption by electronic excitation between subbands. The second to nth levels $L_2$ to $L_n$ constitute an extraction level structure (relaxation level structure) concerning the relaxation, transportation, and extraction of the electrons excited by the light absorption.

Here, the lower detection level $L_{1a}$ is a level corresponding to the ground level in the absorption well layer 141, for example. The upper detection level $L_{1b}$, which is an energy level higher than the lower detection level $L_{1a}$, is a level corresponding to an excited level in the absorption well layer 141, for example. The second to nth levels $L_2$ to $L_n$ are levels caused by respective ground levels in the second to nth well layers, for example. The second to nth levels $L_2$ to $L_n$ are typically set such that the energy decreases sequentially from the second level $L_2$ on the absorption well 141 side to the nth level $L_n$ on the side of the unit multilayer body 46b in the subsequent stage. However, the energy order of these levels may partly be reversed as long as electrons can be transported.

As for energy gaps, the energy gap $\Delta E_{12}$ between the upper detection level $L_{1b}$ and the second level $L_2$ for extracting electrons is set such that the combination between the levels is sufficiently large in view of the migration of electrons caused by a resonant tunneling effect. The magnitude of combination between levels can be evaluated according to the energy gap of anticrossing between the levels.

The energy gap $\Delta E_{23}$ between the second and third levels $L_2$, $L_3$ is set such as to satisfy the following condition:

$$E_{LO} \leq \Delta E_{23} \leq 2 \times E_{LO}$$

where $E_{LO}$ is the longitudinal phonon (LO phonon) energy. The energy gap $\Delta E_{34}$ between the third and fourth levels $L_3$, $L_4$ is set such as to satisfy the following condition:

$$\Delta E_{34} < E_{LO}.$$

Here, the LO phonon energy $E_{LO}$ = 34 meV when the semiconductor material for the quantum well layers is assumed to be InGaAs, for example. The LO phonon energy $E_{LO}$ is 36 meV and 32 meV when the quantum well layers are made of GaAs and InAs, respectively, thus being substantially the same as 34 meV mentioned above. The conditions for setting the interlevel energy gaps $\Delta E_{23}$, $\Delta E_{34}$ with respect to $E_{LO}$ take account of achieving higher speed and higher efficiency in electron transportation in the extraction level structure.

Before light is incident on such a subband level structure, electrons are accumulated at the lower detection level $L_{1a}$ of the absorption well layer 141 by using the doped semiconductor layers. When light hv to be detected is incident on the quantum cascade structure, more specifically on the absorption well layer 141, the electrons at the lower detection level $L_{1a}$ is excited to the upper detection level $L_{1b}$ as the light is absorbed between the subbands. The electrons excited to the upper detection level $L_{1b}$ are rapidly extracted to the second level $L_2$ by the resonant tunneling effect, subjected to relaxation processes such as LO phonon scattering from the second level $L_2$ to the third and fourth levels $L_3$, $L_4$, and speedily transported and extracted to the lower detection level $L_{1a}$ of the absorption well layer of the unit multilayer body 46b in the subsequent stage.

Since thus constructed photodetector 1A is equipped with the optical element 10 in which the first regions R1 made of gold having free electrons and the second regions R2 made of air are periodically arranged along a plane perpendicular to the predetermined direction in the structure 11, a surface plasmon is excited by surface plasmonic resonance when light is incident on the optical element 10 from one side in the predetermined direction (e.g., when a planar wave is incident thereon in the stacking direction of the semiconductor multilayer body 4). Here, an electric field component in the predetermined direction occurs. Further, the structure 11 in the optical element 10 has the film body 13 provided with a plurality of through holes 12 penetrating therethrough from one side to the other side, the first regions R1 are the part 13a between the through holes 12 in the film body 13, and the second regions R2 are the space S within the through hole 12. Therefore, the structure 11 can be formed from a single kind of material and thus is easy to manufacture, while the cost can be cut down.

The electric field component in the predetermined direction generated by exciting the surface plasmon as mentioned above is also an electric field component in the stacking direction of the semiconductor multilayer body 4 and thus can excite an electron in the active region 4b formed on the outermost surface on the optical element 10 side of the quantum cascade structure in the semiconductor multilayer body 4, and this electron is unidirectionally transported by the injector region 4c, so as to produce a current in the quantum cascade structure. This current is detected through the electrodes 6, 7. That is, the photodetector 1A can detect light having no electric field component in the stacking direction of the semiconductor multilayer body 4. Since the electrode 6 supplies electrons, a current continuity condition is satisfied.

Operations in the quantum cascade structure will now be explained in detail. In the photodetector 1A, the first to nth well layers and the first to nth barrier layers are stacked alternately in the quantum cascade structure. The lower and upper detection levels $L_{1a}$, $L_{1b}$ concerning the intersubband electronic excitation are provided in the absorption well layer 141, while the extraction level structure produced by the second to nth levels $L_2$ to $L_n$ concerning the transportation and extraction of electrons to the unit multilayer body 46b in the next period is provided in the extractor structure 48. Such a level structure can favorably achieve a light-detecting action constituted by intersubband light absorption and takeout of the current generated by the light absorption.

In this configuration, the electrons excited to the upper detection level $L_{1b}$ by the light absorption in the well layer 141 are shifted and relaxed to the second level $L_2$ by the resonant tunneling effect, so as to extract the electrons rapidly, while the energy gap between the second and third energy levels $L_2$, $L_3$ in the extraction level structure produced by the second to nth levels $L_2$ to $L_n$ is set such as to satisfy the condition:

$$E_{LO} \leq \Delta E_{23} \leq 2 \times E_{LO}.$$

In such a configuration, the electrons shifted from the upper detection level $L_{1b}$ to the second level $L_2$ by the resonant tunneling effect are rapidly extracted from the

second level $L_2$ to the third and later levels through the LO phonon scattering. This can restrain the electrons excited to the upper level $L_{1b}$ from being relaxed to the lower level $L_{1a}$ again without being transported to the unit multilayer body 46b, so as to improve the efficiency in the light-detecting action.

In the above-mentioned configuration, the energy gap between the third and fourth levels $L_3$, $L_4$ $i_S$ set such as to satisfy the condition:

$$\Delta E_{34} \leq E_{LO}.$$

Thus setting the energy gap between the third and fourth levels $L_3$, $L_4$ smaller than the LO phonon energy so as to place them closer to each other enables a plurality of levels including the third and fourth levels $L_3$, $L_4$ to function as levels to which electrons are extracted from the second level $L_2$ by the LO phonon scattering. This allows electrons to be transported more stably and speedily in the extraction level structure.

Such a configuration in which electrons are extracted to a plurality of levels can stabilize characteristics at the time of manufacturing the photodetector, improve the degree of freedom in crystal growth fluctuations and yield, and so forth, while making it easier to design the structure for extracting electrons. The foregoing can favorably actualize a quantum cascade type photodetector in which carrier electrons excited by the light absorption in the absorption well layer 141 are efficiently caused to function as a forward current, so as to improve the light detection sensitivity for the incident light.

In the quantum cascade structure, electrons can be excited from the lower detection level $L_{1a}$ to the upper detection level $L_{1b}$ and from the lower detection level $L_{1a}$ to the second level $L_2$. The absorption well layer 141 thus has two upper quantum levels with different electronic excitation energies, which makes it possible to detect two kinds of wavelengths of light corresponding to the respective electronic excitation energies to the upper quantum levels. That is, the photodetector 1A can be said to have widened its sensitive wavelength band. Kazuue Fujita, et al., "High-performance, homogeneous broad-gain quantum cascade lasers based on dual-upper-state design", Appl. Phys. Lett., 96, 241107 (2010) has been known as a technique forming two upper quantum levels to which electrons are excited in a quantum cascade structure, though it is an example applied to a quantum cascade laser.

Since the photodetector 1A further comprises the substrate 2 for supporting the contact layers 3, 5, semiconductor multilayer body 4, and optical element 10, the constituents of the photodetector 1A are stabilized.

While the photodetector disclosed in the above-mentioned Non Patent Literature 1 has been known as a photodetector utilizing surface plasmonic resonance, it employs a QWIP structure in which quantum wells having the same well width are simply stacked, thus requiring a bias voltage to be applied from the outside in order to operate as a photodetector, whereby adverse effects of the resulting dark current on photosensitivity cannot be ignored. By contrast, the photodetector 1A of this embodiment is designed such that the injector region 4c unidirectionally transports the electron excited by the active region 4b and thus needs no bias voltage to be applied from the outside for its operation, so that electrons excited by light migrate while scattering between quantum levels without bias voltages, whereby the dark current is very small. In the photodetector 1A of this embodiment, the active region 4b is formed on the outermost surface on one side of the injector region 4c, i.e., on the side provided with the optical element 10, in the quantum cascade structure, and thus can be strongly influenced by the electric field component in the predetermined direction caused by the optical element 10. Therefore, with high sensitivity, this photodetector 1A can detect light having such a low intensity as to have no electric field component in the stacking direction of the semiconductor multilayer body. For example, this photodetector can detect weaker light than does a detector using PbS(Se) or HgCdTe, which has conventionally been known as a mid-infrared photodetector.

On the other hand, the photodetector disclosed in the above-mentioned Patent Literature 1 has a low degree of freedom in designing as a photodetector, since the diffraction grating is formed on the surface of the light-transmitting layer. In the photodetector 1A of this embodiment, by contrast, the optical element 10 is formed separately from the contact layer 5, so that there are wide ranges of selections for materials for exciting surface plasmons and for techniques for forming and processing the optical element 10. Therefore, the photodetector 1A of this embodiment has a high degree of freedom in designing according to the wavelength of incident light, desired photosensitivity, and the like.

In the photodetectors disclosed in the above-mentioned Patent Literature 3 and Non Patent Literature 2 aimed at widening the band of wavelengths to be detected, quantum well structures which absorb light are distributed from the surface layer to deep layers of the semiconductor multilayer body, whereby light absorption will be less in the deep layers (parts far from the light entrance side) unless they can uniformly be provided with electric field components in the stacking direction which are required for photoelectric conversion. In the photodetector 1A of this embodiment, by contrast, the active region 4b having a quantum well layer adapted to absorb light exists at a limited depth in the semiconductor multilayer body 4, whereby the electric field component in the predetermined direction caused under the action of the optical element 10 can be captured efficiently, which raises the efficiency in photoelectric conversion in the semiconductor multilayer body 4.

The photodetector 1A of the above-mentioned first embodiment may have the optical element 10 in another mode. For example, as illustrated in Fig. 6, the plurality of through holes 12 provided in the film body 13 in the optical element 10 may have cylindrical forms and be arranged into a square lattice in a planar view. While surface plasmons are excited by only the light polarized in the direction along which the slit-shaped through holes are arranged in a row in the photodetector 1A of the above-mentioned embodiment, the photodetector of the embodiment equipped with the optical element 10 illustrated in Fig. 6, in which the first and second regions R1, R2 are periodically arranged two-dimensionally, increases the polarization directions of incident light that can excite surface plasmons to two kinds.

The plurality of cylindrical through holes may be arranged into a triangular lattice as illustrated in Fig. 7 instead of the square lattice. This is less dependent on the polarization direction of incident light than the square lattice arrangement.

**Second Embodiment**

Another mode of the photodetector will now be explained as the second embodiment of the present invention. The photodetector 1B of the second embodiment illustrated in Fig. 8 differs from the photodetector 1A of the first embodiment in that it comprises, as an optical element, an optical element 20 made of a dielectric body having a large refractive index in place of the optical element 10 made of gold.

This optical element 20 is an optical element for transmitting therethrough light from one side to the other side in the predetermined direction, in which the first regions R1 are made of the dielectric body having a large refractive index. The difference between the refractive index of the first regions (dielectric body) R1 and that of the second regions (air) R2 is preferably at least 2, more preferably at least 3. For infrared light having a wavelength of 5 $\mu$m, for example, germanium and air have refractive indexes of 4.0 and 1.0, respectively. In this case, the refractive index difference is 3.0. The thickness of the film body 13 in the optical element 20 is preferably 10 nm to 2 $\mu$m.

Since thus constructed photodetector 1B is equipped with the above-mentioned optical element 20, light incident on the optical element 20 from one side in the predetermined direction (e.g., a planar wave incident thereon in the stacking direction of the semiconductor multilayer body 4), if any, is modulated by the difference between the refractive indexes of the first and second regions R1, R2 arranged periodically along a plane perpendicular to the predetermined direction in the structure 11 and then emitted from the other side in the predetermined direction. That is, light having no electric field component in a predetermined direction can efficiently be modulated so as to have an electric field component in the predetermined direction. The difference between the respective refractive indexes of the first and second regions R1, R2 is at least 2, while the period d of arrangement of the first and second regions R1, R2 is 0.5 to 500 $\mu$m and determined according to the wavelength of incident light, whereby the light is modulated more efficiently.

In the photodetector of the above-mentioned first embodiment, incident light (infrared ray here) is partly blocked by a thin film of gold, while surface plasmonic resonance itself tends to incur large energy loss, which may lower photosensitivity. For utilizing surface plasmonic resonance, which refers to the state of resonance of a vibration occurring as a result of a combination of a free electron in a metal with an electric field component of light and the like, there is a limitation that the free electron must exist on the surface on which the light is incident. By contrast, the photodetector 1 of this embodiment, in which each of the first and second regions R1, R2 transmits the incident light therethrough and does not use surface plasmonic resonance, is advantageous in that photosensitivity does not lower as might be feared in the photodetector of the first embodiment and that materials for use are not limited to metals having free electrons.

The photodetector 1B of the above-mentioned second embodiment may have the optical element 20 in another mode as with the photodetector 1A of the first embodiment. That is, the plurality of through holes 12 provided in the film body in the optical element 20 may have cylindrical forms and be arranged into a square or triangular lattice in a planar view. The through holes may be filled with silicon dioxide, silicon nitride, aluminum oxide, and the like, so as to construct the second regions.

**Third Embodiment**

Another mode of the photodetector will now be explained as the third embodiment of the present invention. The photodetector 1C of the third embodiment illustrated in Fig. 9 differs from the photodetector 1A of the first embodiment in that the contact layer 5 is disposed only directly under the electrode 6 instead of all over the surface 4a of the semiconductor multilayer body 4 and that the optical element is accordingly provided directly on the surface 4a of the semiconductor multilayer body 4. The optical element 20 of the second embodiment may be employed in place of the optical element 10. As can be seen from calculation results which will be explained later, the electric field component in a predetermined direction generated by light incident on the optical element from one side in the predetermined direction appears most strongly near the surface on the other side of the optical element. Therefore, the photodetector 1C of this embodiment, in which the optical element 10 and the semiconductor multilayer body 4 are in direct contact with each other, exhibits higher photosensitivity than the photodetector 1A of the first embodiment does.

**Fourth Embodiment**

Another mode of the photodetector will now be explained as the fourth embodiment of the present invention. The photodetector 1D of the fourth embodiment illustrated in Figs. 10 and 11 differs from the photodetector 1C of the third embodiment in that an intermediate member 10a made of the material (gold here) forming the optical element 10 is arranged between the contact layer 5 and the electrode 6 and also enters a region between the inner side face of the contact layer 5 and the optical element 10, so as to connect the optical element 10 electrically to the contact layer 5 and electrode 6. This can restrain photosensitivity from being lowered by losses in series resistance even when the optical element 10 is directly provided on the surface 4a of the semiconductor multilayer body 4.

### Fifth Embodiment

Another mode of the photodetector will now be explained as the fifth embodiment of the present invention. The photodetector 1E of the fifth embodiment illustrated in Figs. 12 and 13 differs from the photodetector 1A of the first embodiment in that a semi-insulating type InP substrate is used as the substrate 2c, that the semiconductor multilayer body 4 has an area smaller than the whole surface 3a of the contact layer 3 and is disposed at the center of the surface 3a of the contact layer 3 instead of all over the surface, and that the electrode 7 is formed like a ring so as to surround the semiconductor multilayer body 4 in a region of the surface 3a of the contact layer 3 which is free of the semiconductor multilayer body 4. The electrode 7 can be formed by once stacking the contact layer 3, semiconductor multilayer body 4, and contact layer 5 and then etching the contact layer 5 and semiconductor multilayer body 4 away, so as to expose the surface 3a of the contact layer 3. Using the semi-insulating type substrate 2c exhibiting low electromagnetic induction makes it easier to achieve lower noise, higher speed, and integrated circuits with amplifier circuits and the like.

Since no electrode is provided on the surface of the substrate 2c on the side opposite from the contact layer 3, light can be made incident on the photodetector 1E from its rear side (the other side in the predetermined direction) and detected. This can prevent the optical element 10 from reflecting and absorbing the incident light and thus can further enhance photosensitivity. Further, while the photodetector 1E is mounted by flip chip bonding onto a package, a submount, an integrated circuit, or the like, light can easily be made incident thereon, which has a merit in that it expands possibility of developing into image sensors and the like in particular.

This embodiment may also use the n-type InP substrate as its substrate.

### Sixth Embodiment

Another mode of the photodetector will now be explained as the sixth embodiment of the present invention. The photodetector 1F of the sixth embodiment illustrated in Figs. 14 and 15 differs from the photodetector 1B of the second embodiment in that it uses an optical element 30 having a different form as its optical element and that the semiconductor multilayer body 4 has a plurality of quantum cascade structures (i.e., unit multilayer bodies 46) stacked along the predetermined direction as illustrated in Fig. 5.

The optical element 30 is one in which a plurality of rod-shaped bodies 33a (first regions Rl) each extending in a direction perpendicular to the predetermined direction are arranged in parallel with each other on the same plane so as to form stripes with a space S (second regions R2).

As can be seen from a simulation which will be explained later, the electric field component in the predetermined direction is the strongest in a part near the surface layer of the optical element 30 and decays with depth, but still exists in a deep region of the semiconductor multilayer body 4 without its strength becoming zero. Since the semiconductor multilayer body 4 has a plurality of stages of quantum cascade structures, the electric field component having reached the deep region also generates photoexcited electrons effectively. Therefore, the photodetector of this embodiment can be said to have further enhanced photosensitivity.

While preferred embodiments of the present invention are explained in the foregoing, the present invention is not limited thereto at all. For example, while the above-mentioned embodiments set forth examples in which the quantum cascade structures formed on the InP substrate are constituted by InAlAs and InGaAs, any semiconductor layers which can form quantum levels, such as those constituted by InP and InGaAs, AlGaAs and GaAs formed on GaAs substrates, and GaN and InGaN, may also be employed.

While the first embodiment represents gold (Au) as a material for the optical element 10, other metals exhibiting low electric resistance such as aluminum (Al) and silver (Ag) may also be used. While the second embodiment represents germanium (Ge) as a dielectric body having a high refractive index which is a material for the optical element 10, it is not restrictive. The metals constituting the ohmic electrodes 6, 7 in the above-mentioned embodiments are also not limited to those set forth herein. Thus, the present invention can be employed within the range of variations in device forms which are typically thought of.

The optical element 20 of the second embodiment may be employed in place of the optical element 10 in the photodetectors of the fourth and fifth embodiments, and a material known as metamaterial whose permittivity and permeability are artificially manipulated by a fine processing technique as disclosed in a literature (M. Choi et al., "A terahertz metamaterial with unnaturally high refractive index", Nature, 470, 369 (2011)) may be used as a material constituting the first and second regions.

In the photodetector of the present invention, the optical element may generate an electric field component in a predetermined direction when light is incident thereon from either one side in the predetermined direction or through the semiconductor multilayer body from the other side of the predetermined direction. That is, the optical element of the present invention generates an electric field component in a predetermined direction when light is incident thereon along the predetermined direction.

For the first and second regions R1, R2 in the optical element, the size ratio (width ratio) in the direction in which they are periodically arranged is not limited in particular. For example, the width of the first regions R1 may be configured smaller or larger than that of the second regions R2. They may be designed freely according to their purposes.

**Examples**

An electric field strength distribution near the light exit side was calculated by simulation for the optical element in the present invention.

The optical element 20 illustrated in Fig. 8 was employed. The thickness of the optical element 20 and the constituent materials and sizes of the first and second regions R1, R2 are as follows:

Thickness of the optical element: 0.5 μm
Period d = 1.5 μm
First regions: germanium (refractive index 4.0), width 0.7 μm
Second regions: air (refractive index 1.0), width 0.8 μm

The electric field strength distribution was calculated by a successive approximation method known as FDTD (Finite-Difference Time-Domain) method. Fig. 16 illustrates results. Here, the incident light is a planar wave having a wavelength of 5.2 μm directed from the lower side to the upper side in Fig. 16 (i.e., in the predetermined direction). The polarization direction is the direction in which the slits of the optical element 20 are arranged in a row. Fig. 16 illustrates the strength of an electric field component in a direction along a plane formed by the first and second regions R1, R2 (i.e., a plane perpendicular to the predetermined direction) in the optical element 20.

The incident light is a uniform planar wave, whose electric field components exist only laterally. It is seen from Fig. 16 that electric field components in the predetermined direction which are not included in the incident light are newly generated by the periodic arrangement of the first and second regions (germanium and air). Their strength distribution shows that regions exhibiting high vertical electric field strength are concentrated in areas near the surface layer of the optical element 20, which indicates that higher photosensitivity is obtained when the active region 4b is formed as close as possible to the surface layer of the semiconductor multilayer body 4.

Photodetectors equipped with optical elements made of germanium were actually produced, and their photosensitivity spectra were plotted. Fig. 17 illustrates the photosensitivity spectra. Each of the photodetectors produced has an optical element made of germanium formed into stripes (the form of Fig. 3). The optical element has a period of 1.5 μm and a width of 0.8 μm. The semiconductor structure is constituted by InGaAs well layers and InAlAs barrier layers. The substrate is made of n-type InP.

As seen from Fig. 17, while a conventional example having one upper quantum level in the quantum well layer in the active region has one photosensitivity peak, an example of the present invention provided with two upper quantum levels is seen to have two photosensitive peaks corresponding to respective electronic excitation energies to these levels. This shows that the sensitive wavelength band of the photodetector is widened in the example of the present invention.

Fig. 18 illustrates an example of calculating an integrated value of vertical electric field strength occurring throughout the inside of the semiconductor multilayer body while changing the number of stages of quantum cascade structures. It is seen from Fig. 18 that the vertical electric field strength increases with the number of stages at least until the number of stages is 50 and tends to be saturated at greater numbers of stages. These results show that the number of stages of quantum cascade structures is preferably several tens.

**Reference Signs List**

1A, 1B, 1C, 1D, 1E, 1F: photodetector; 2, 2c: substrate; 3, 5: contact layer; 4: semiconductor multilayer body; 4b: active region; 4c: injector region; 6, 7: electrode; 10, 20, 30: optical element; 11: structure; R1: first region; R2: second region

**Claims**

**1.** A photodetector comprising:

an optical element, having a structure including first regions and second regions periodically arranged with respect to the first regions along a plane perpendicular to a predetermined direction, for generating an electric field component in the predetermined direction when light is incident thereon along the predetermined direction; and

a semiconductor multilayer body having a quantum cascade structure, arranged on the other side opposite from one side in the predetermined direction with respect to the optical element, for producing a current according to the electric field component in the predetermined direction generated by the optical element;
wherein the quantum cascade structure includes:

an active region having a first upper quantum level and a second upper quantum level lower than the first upper quantum level; and
an injector region for transporting an electron excited by the active region.

**2.** A photodetector according to claim 1, wherein the semiconductor multilayer body has a plurality of quantum cascade structures stacked along the predetermined direction.

**3.** A photodetector according to claim 1 or 2, further comprising:

a first contact layer formed on a surface on the one side of the semiconductor multilayer body; and
a second contact layer formed on a surface on the other side of the semiconductor multilayer body.

**4.** A photodetector according to claim 3, further comprising:

a first electrode electrically connected to the first contact layer; and
a second electrode electrically connected to the second contact layer.

**5.** A photodetector according to claim 3 or 4, further comprising a substrate having the second contact layer, semiconductor multilayer body, first contact layer, and optical element stacked thereon successively from the other side.

**6.** A photodetector according to one of claims 1 to 5, wherein the first regions are constituted by a dielectric body adapted to transmit therethrough light along the predetermined direction and modulate the light.

**7.** A photodetector according to one of claims 1 to 5, wherein the first regions are constituted by a metal adapted to excite a surface plasmon with the light.

**8.** A photodetector according to one of claims 1 to 7, wherein the period of arrangement of the second regions with respect to the first regions is 0.5 to 500 $\mu$m.

**9.** A photodetector according to one of claims 1 to 8, wherein the light is an infrared ray.

**10.** A photodetector according to one of claims 1 to 9, wherein the optical element generates the electric field component in the predetermined direction when light is incident thereon from the one side.

**11.** A photodetector according to one of claims 1 to 9, wherein the optical element generates the electric field component in the predetermined direction when light is incident thereon through the semiconductor multilayer body from the other side.

Fig.1

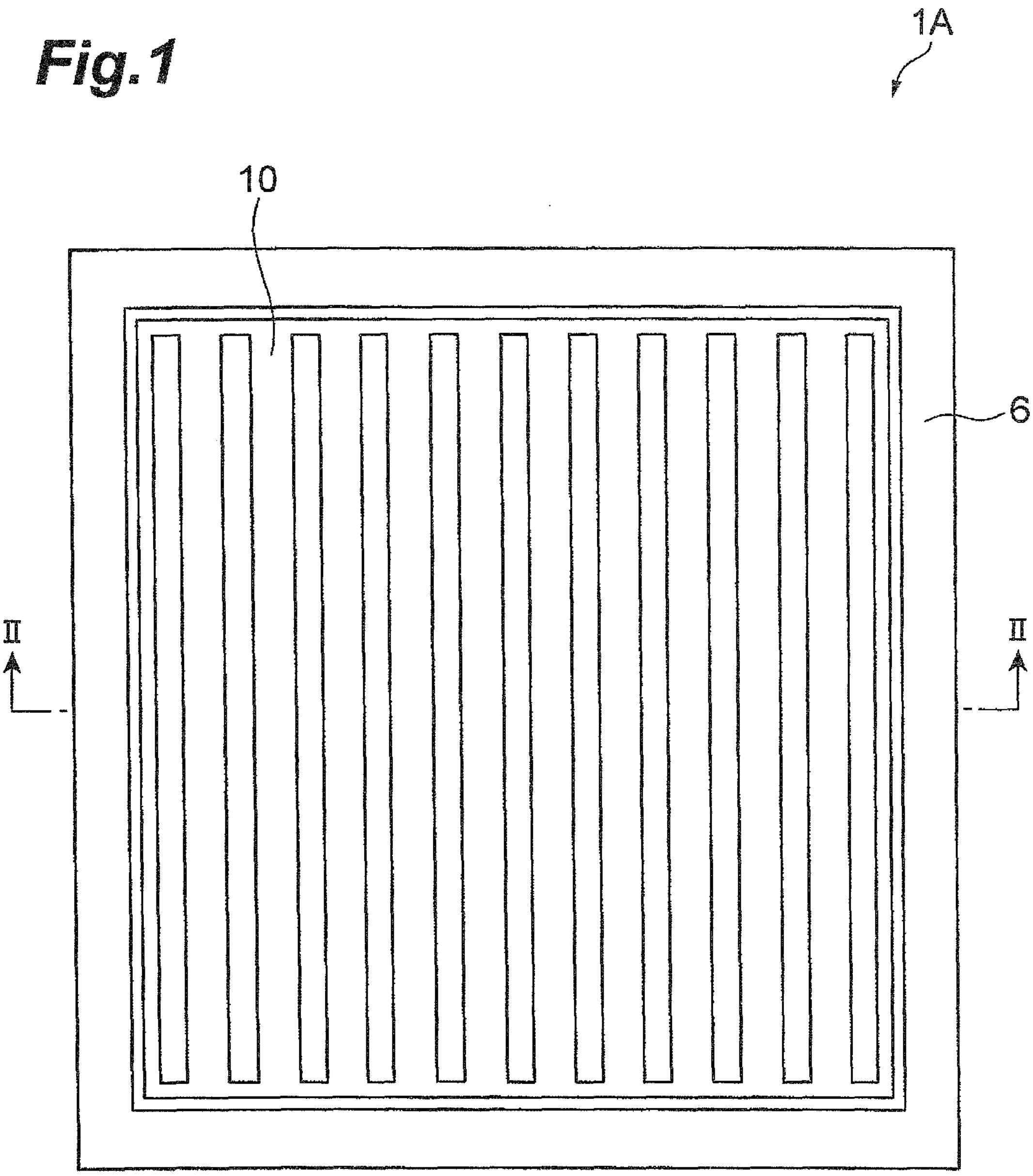

*Fig.2*

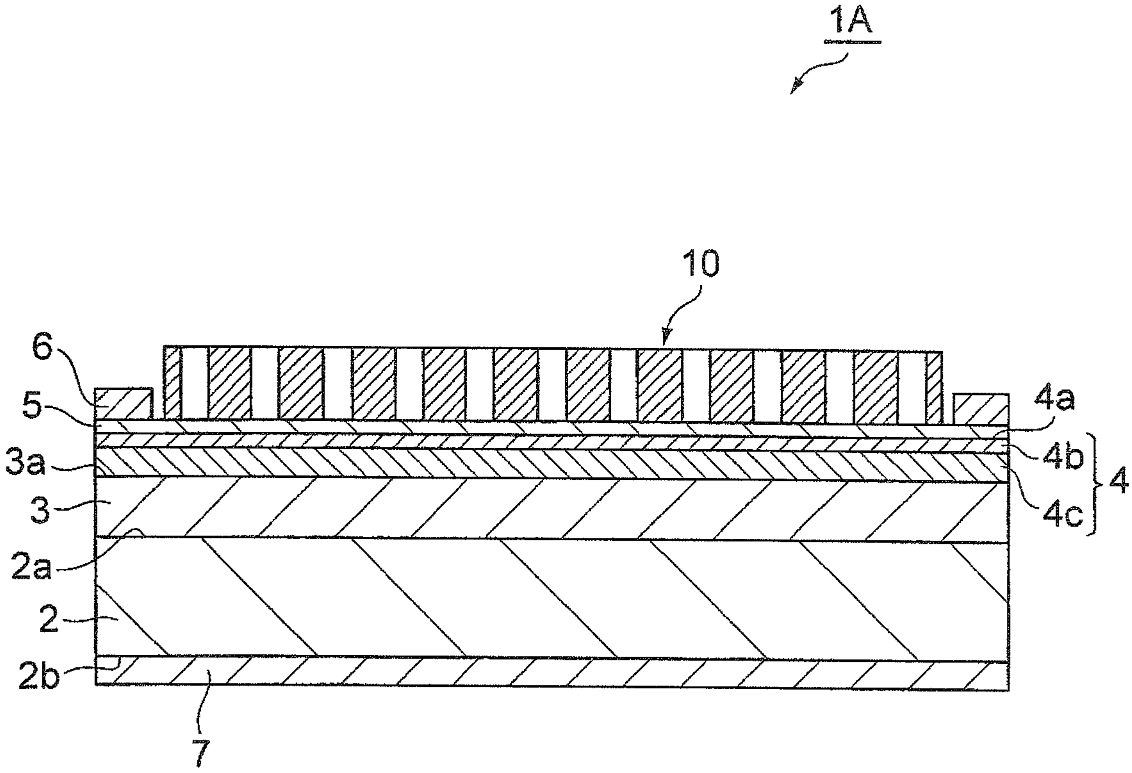

Fig.3

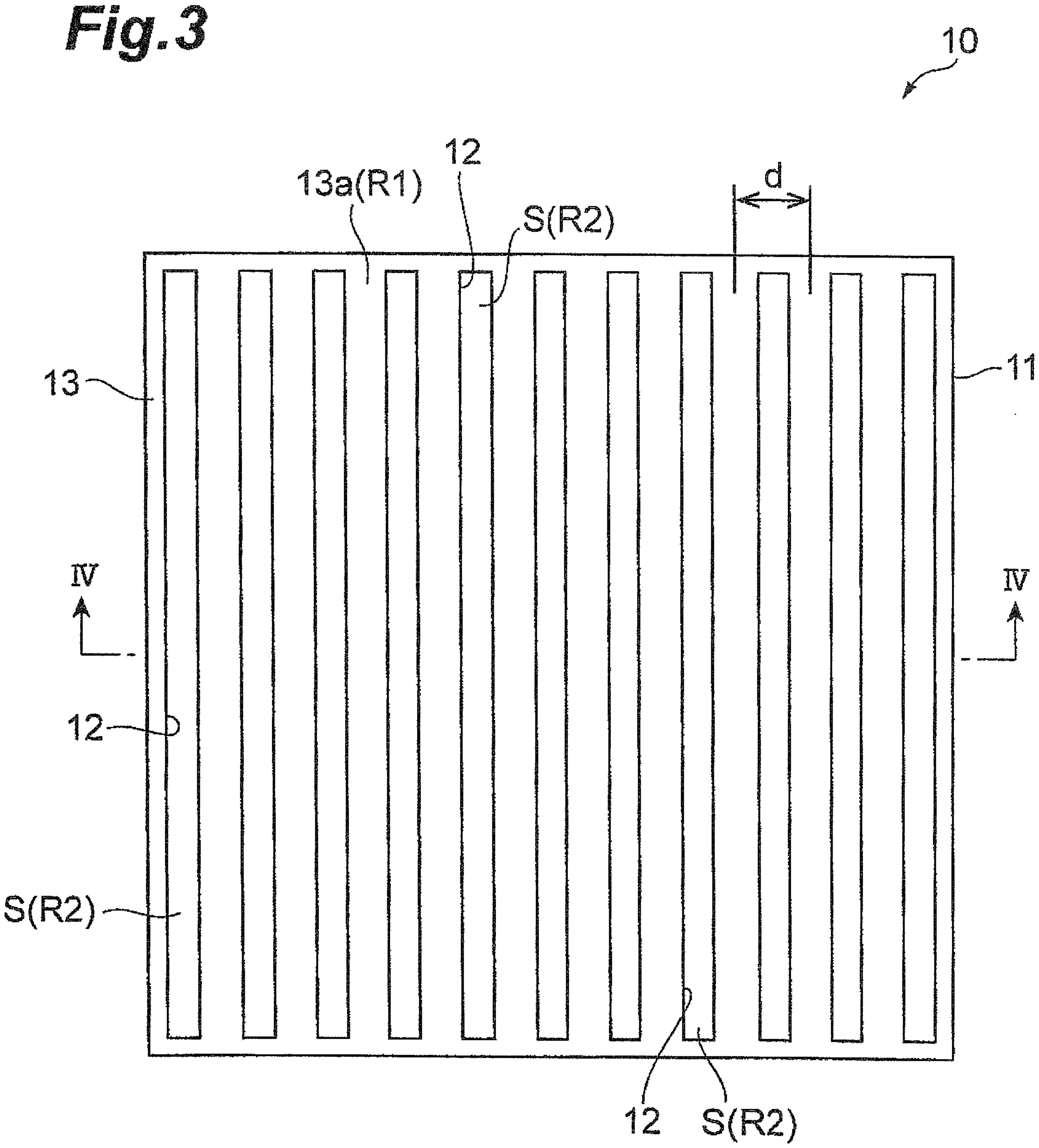

Fig.4

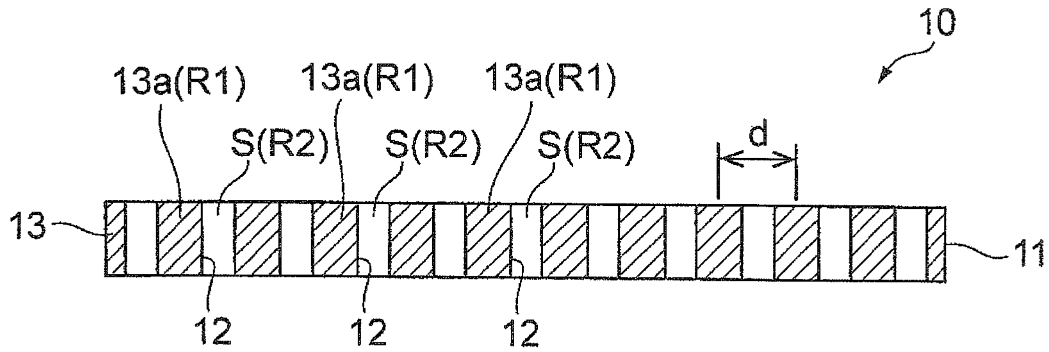

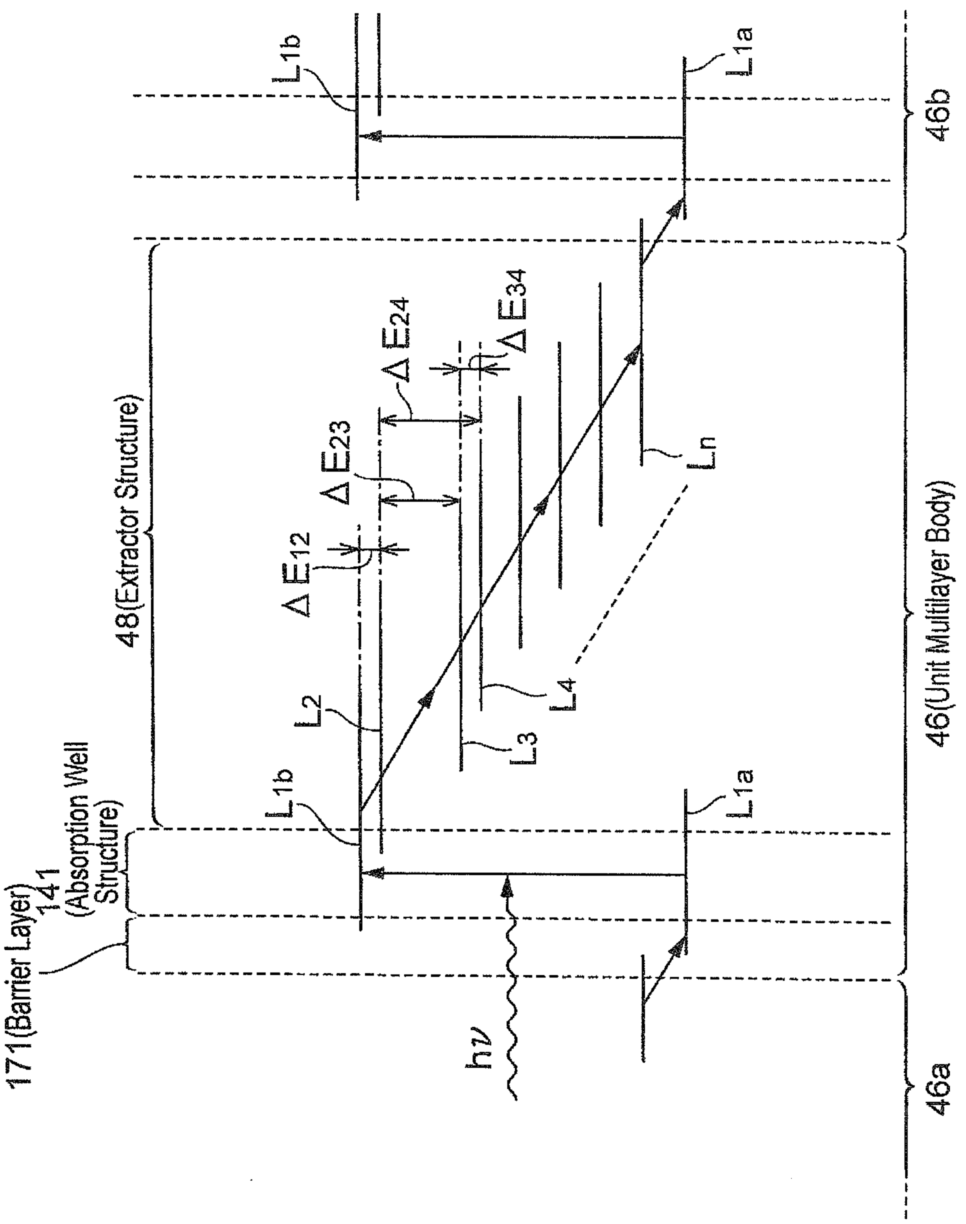

171(Barrier Layer)
141 (Absorption Well Structure)
48(Extractor Structure)
46(Unit Multilayer Body)
46a
46b
hν
$L_{1a}$
$L_{1b}$
$L_2$
$L_3$
$L_4$
$L_n$
$\Delta E_{12}$
$\Delta E_{23}$
$\Delta E_{24}$
$\Delta E_{34}$


*Fig.5*

Fig.6

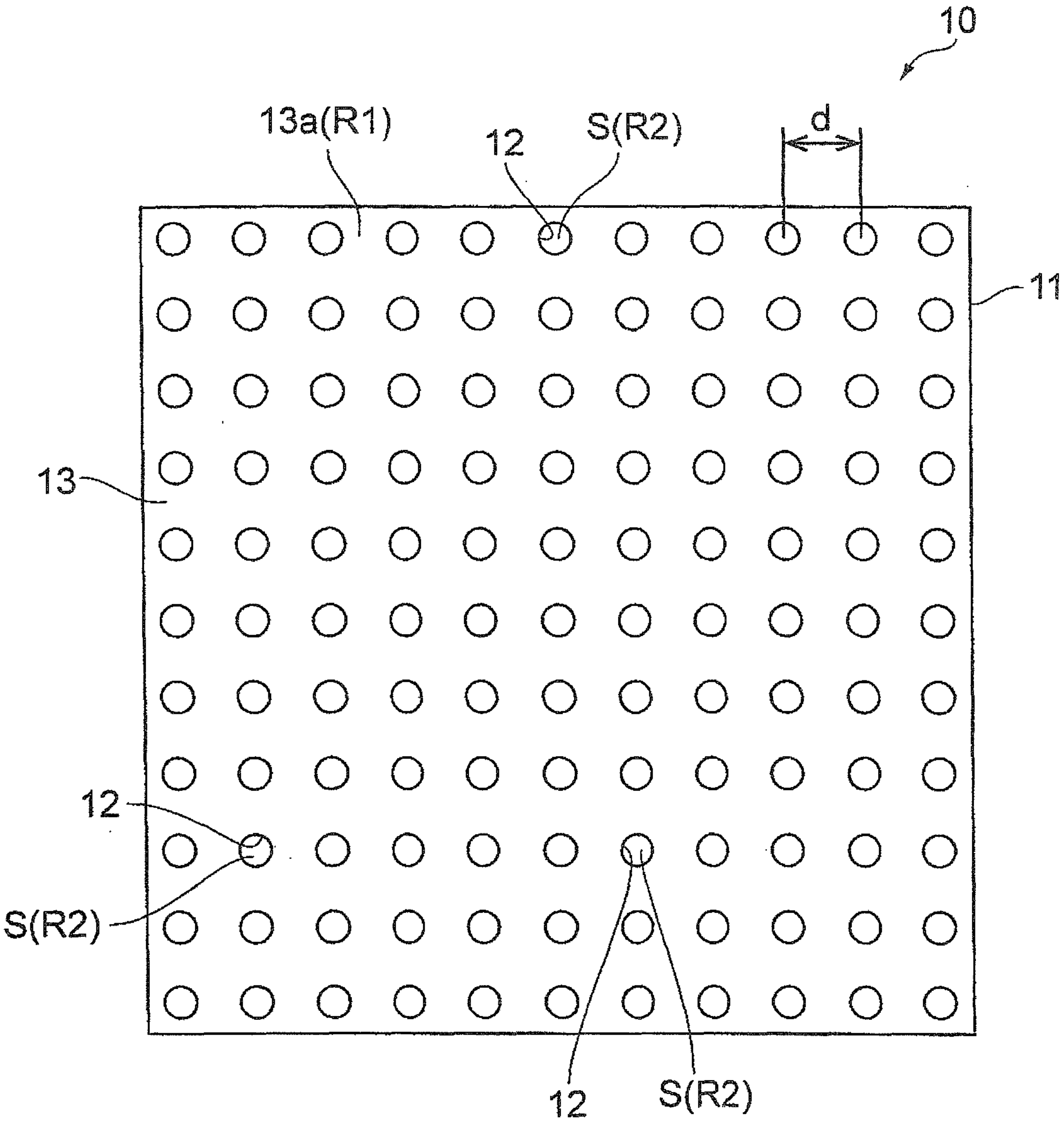

Fig.7

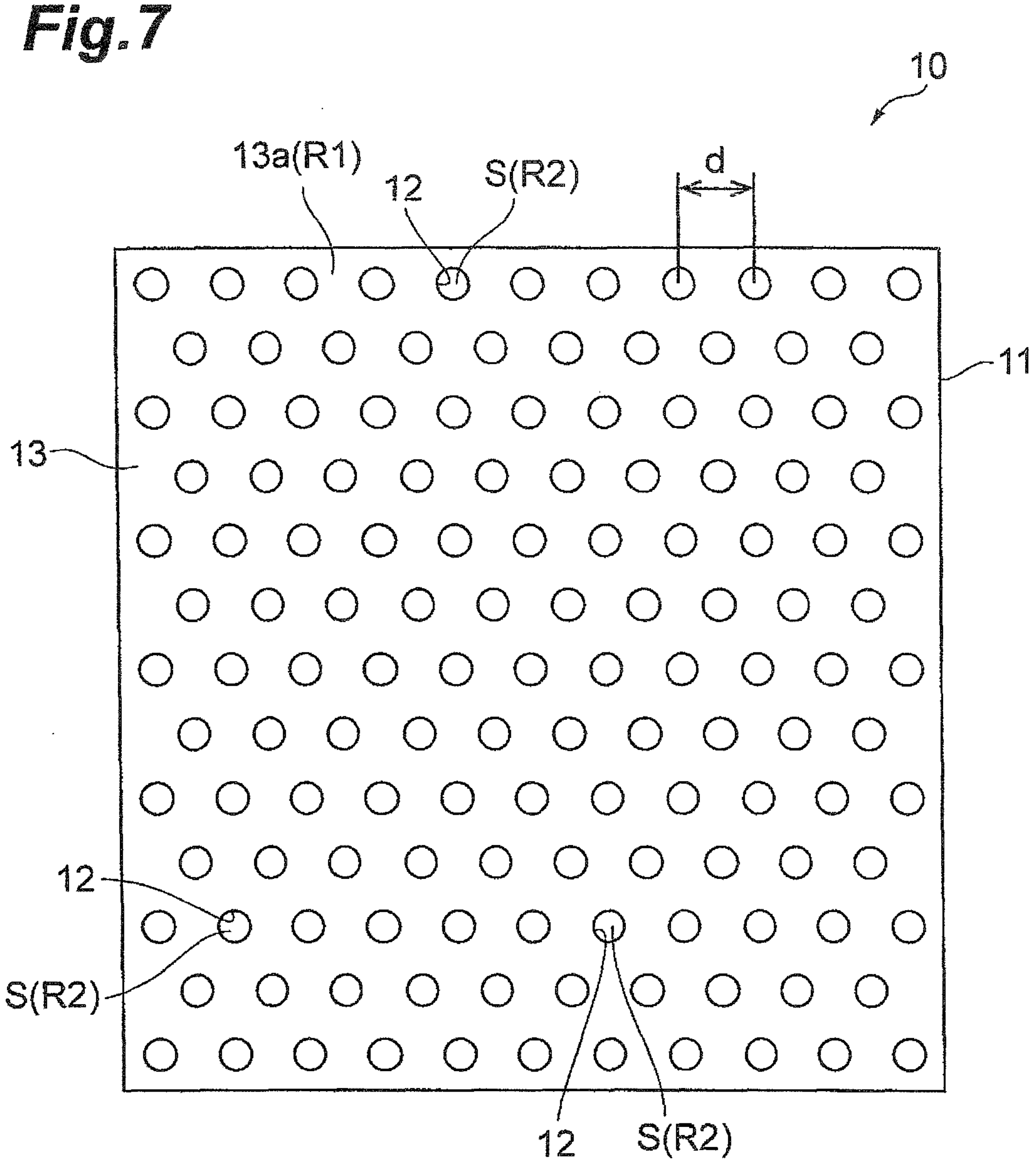

*Fig.8*

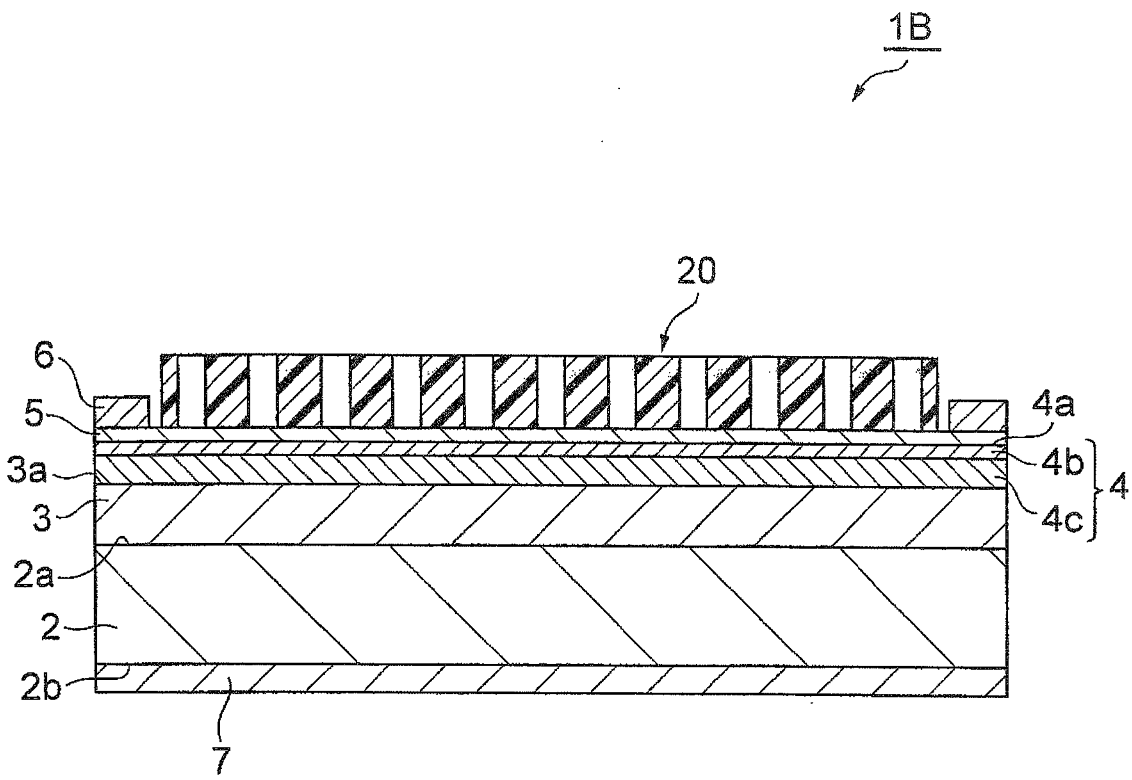

*Fig.9*

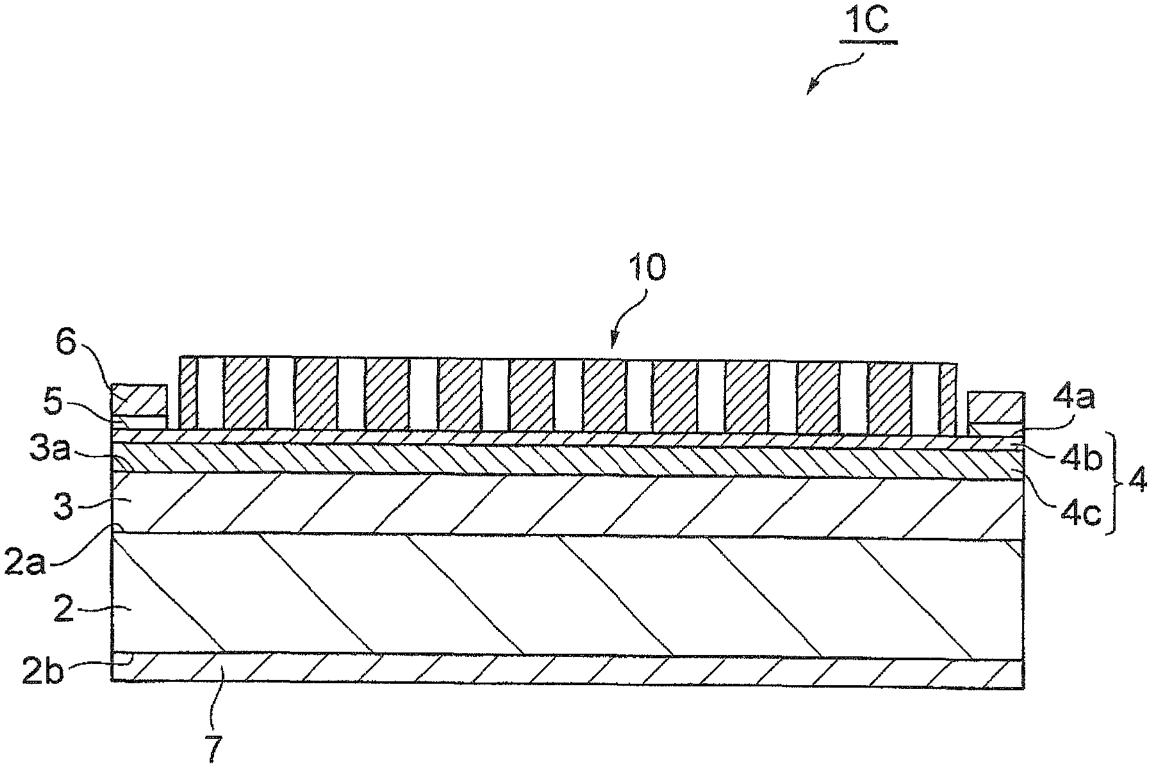

*Fig.10*

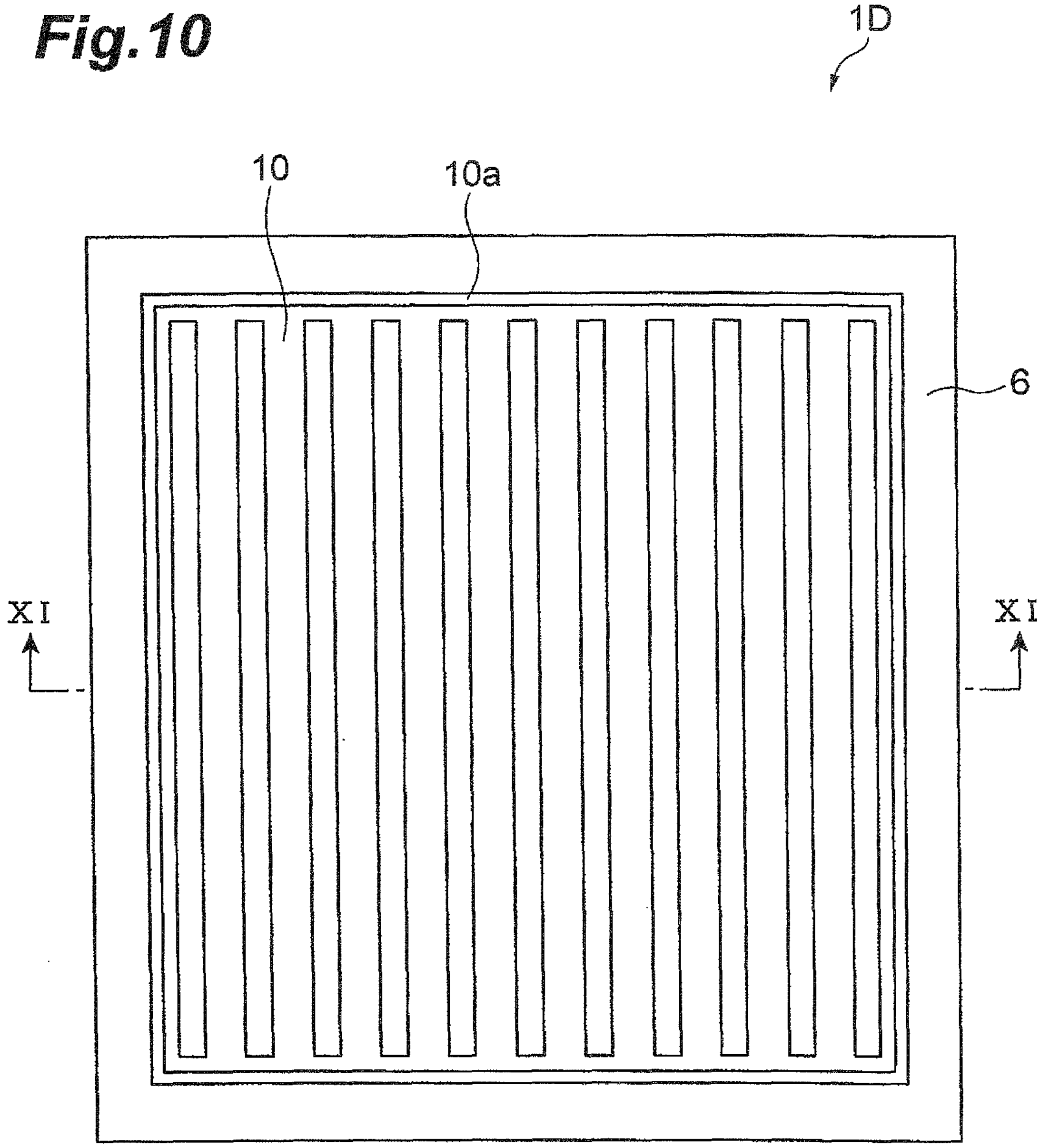

*Fig.11*

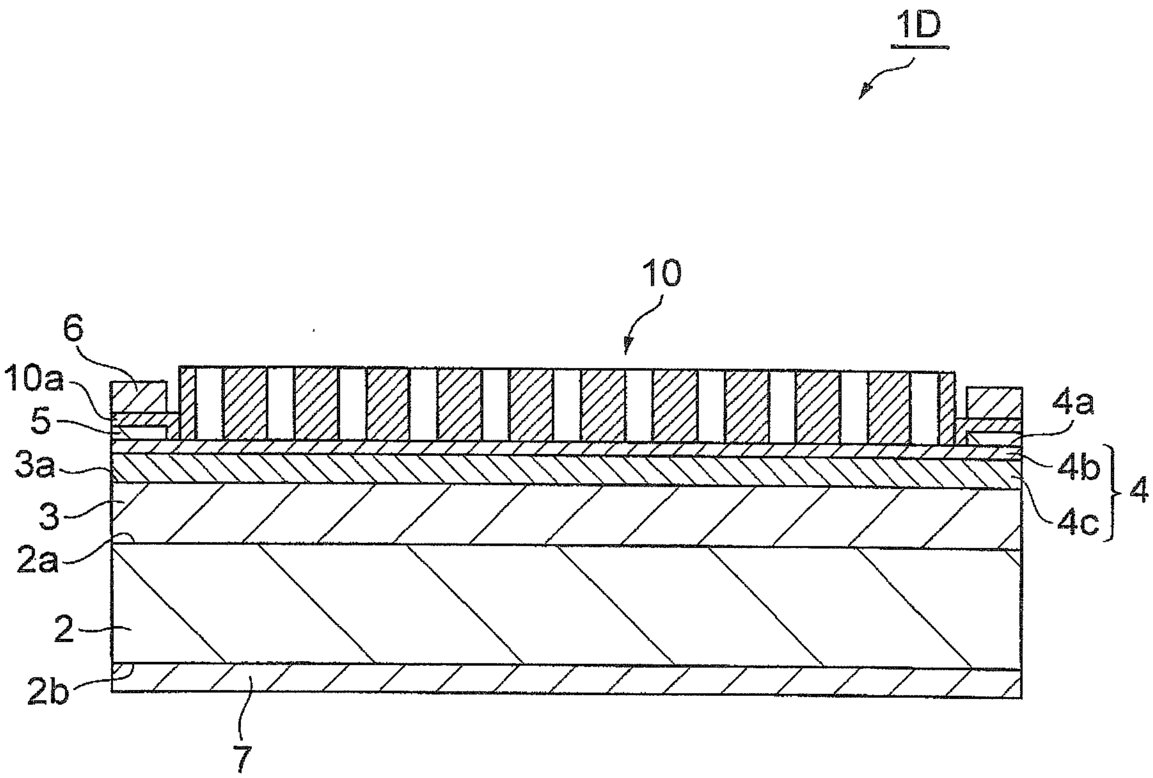

*Fig.12*

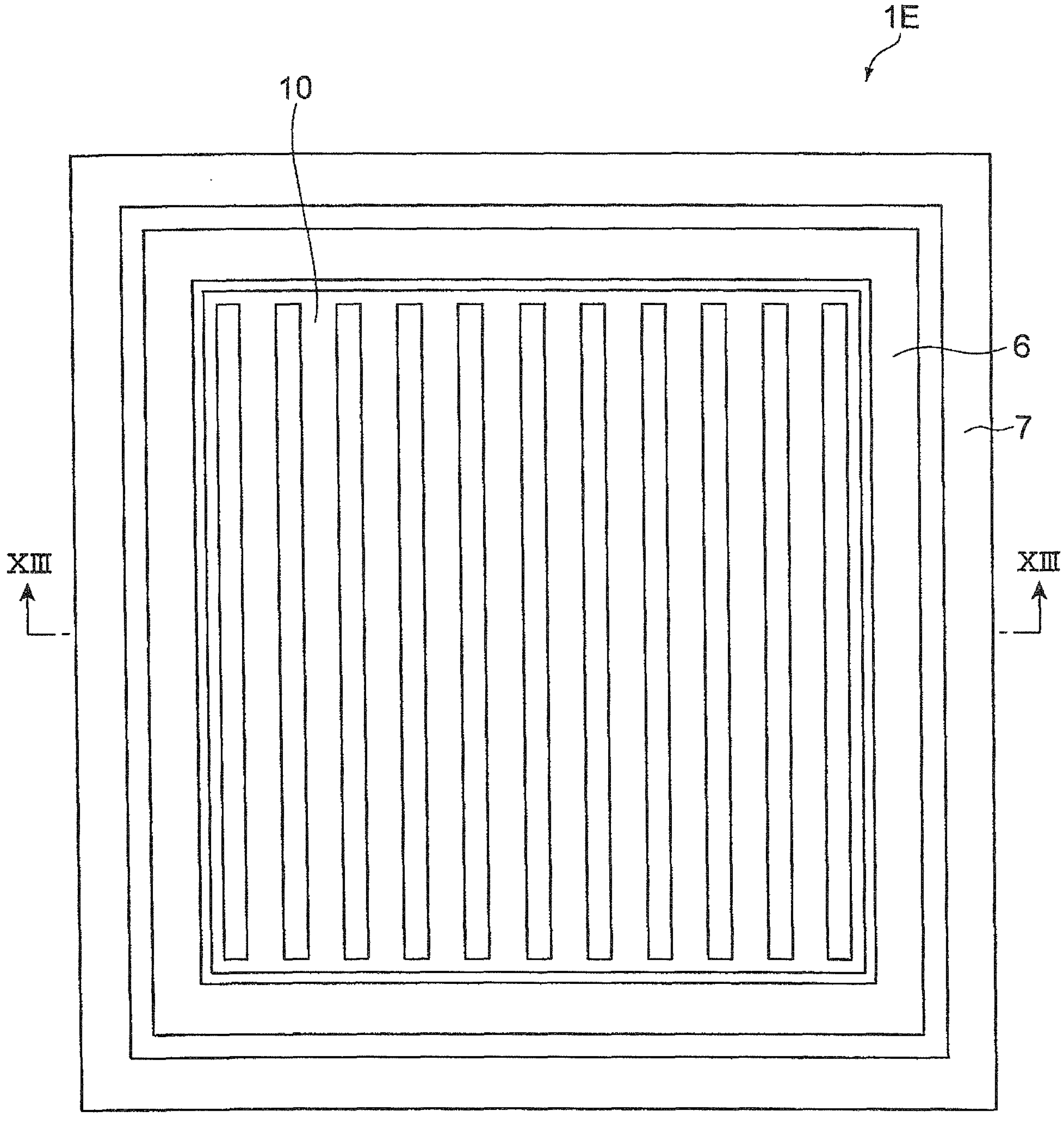

*Fig.13*

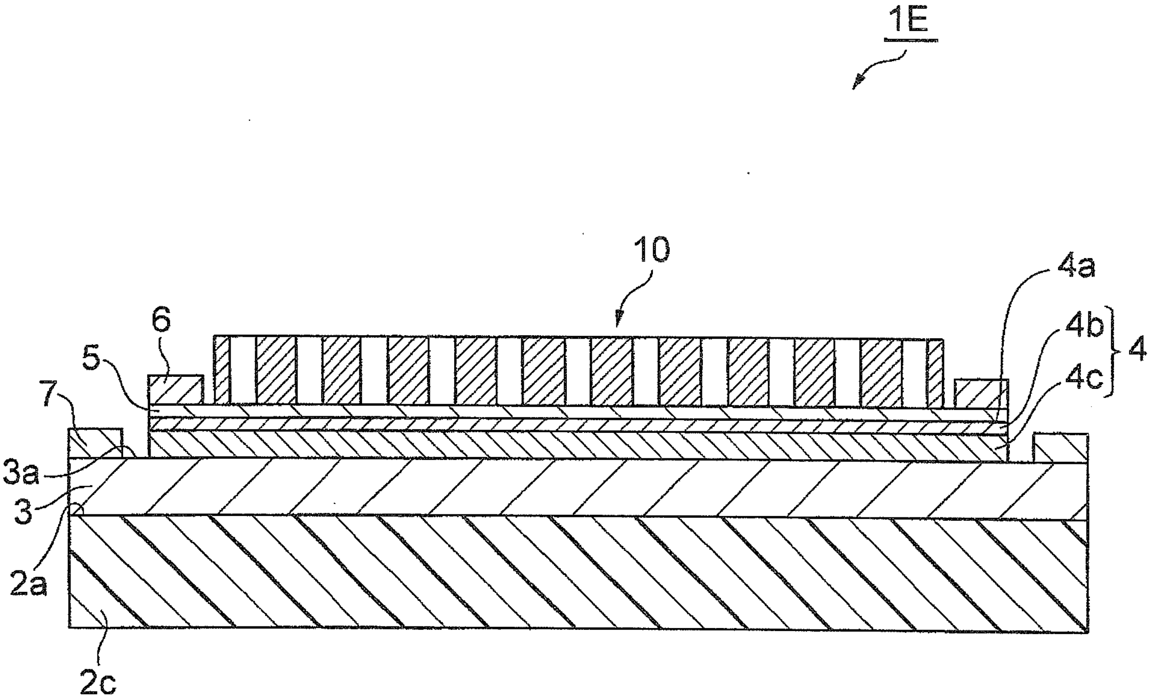

Fig.14

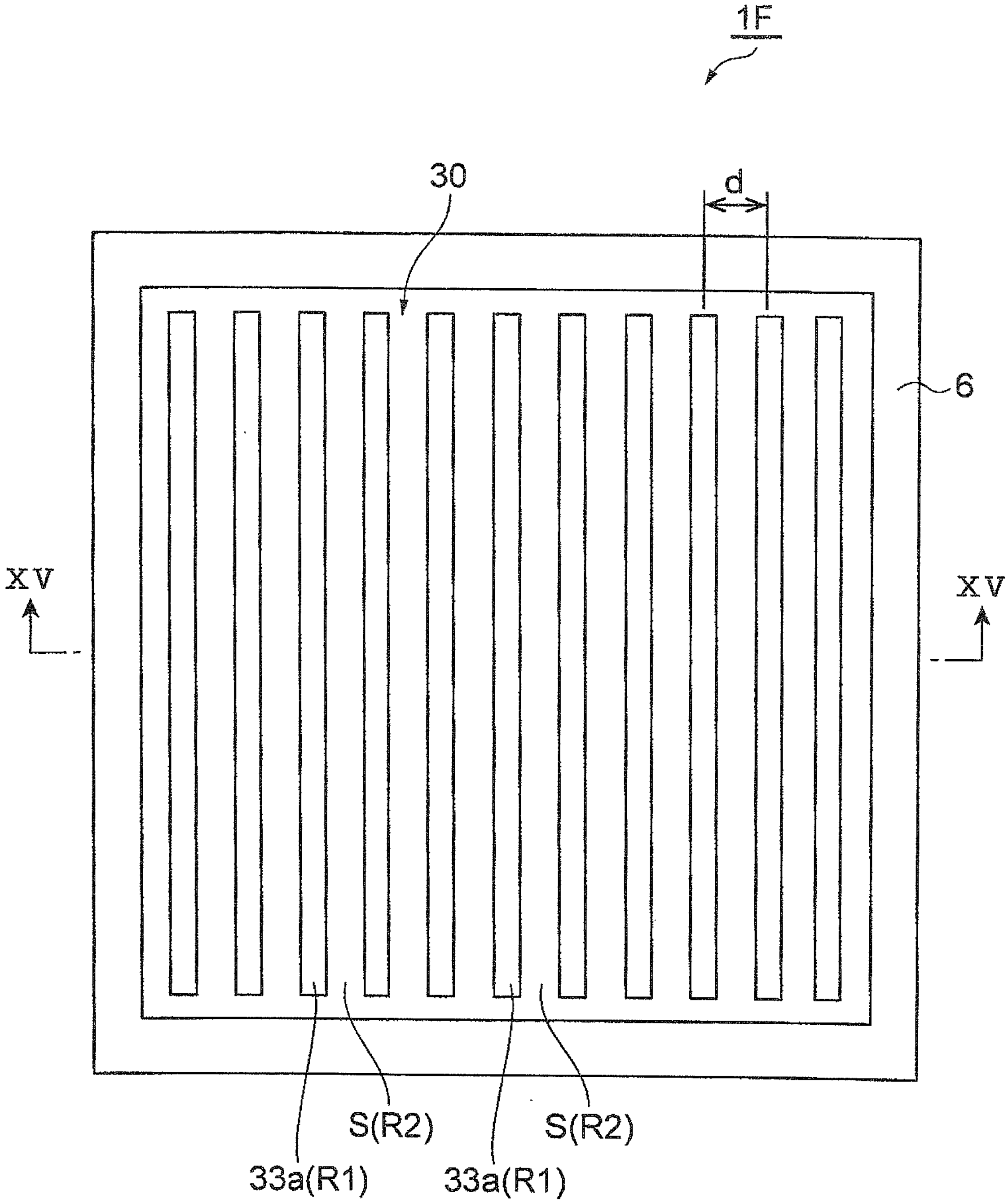

*Fig.15*

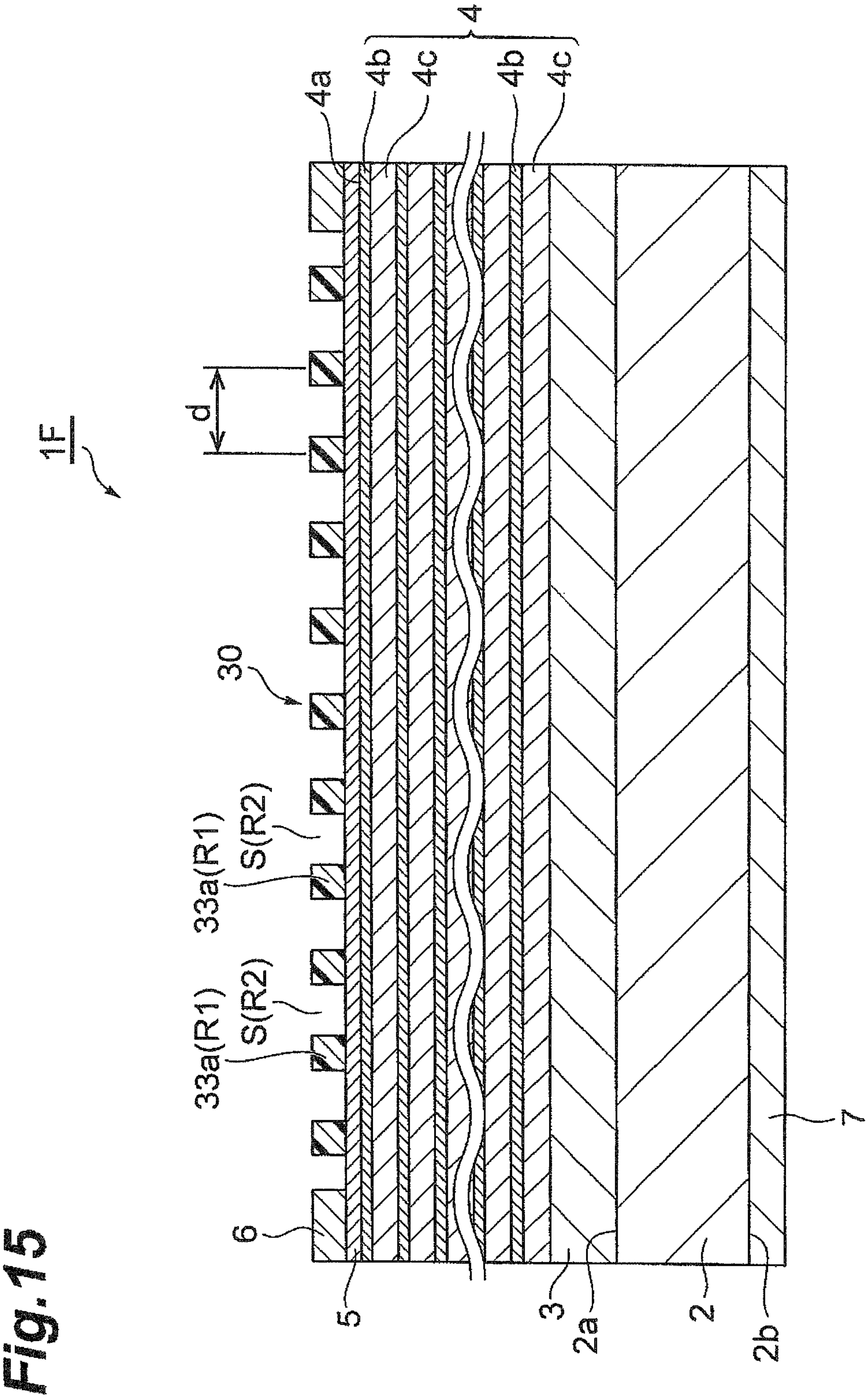

*Fig.16*

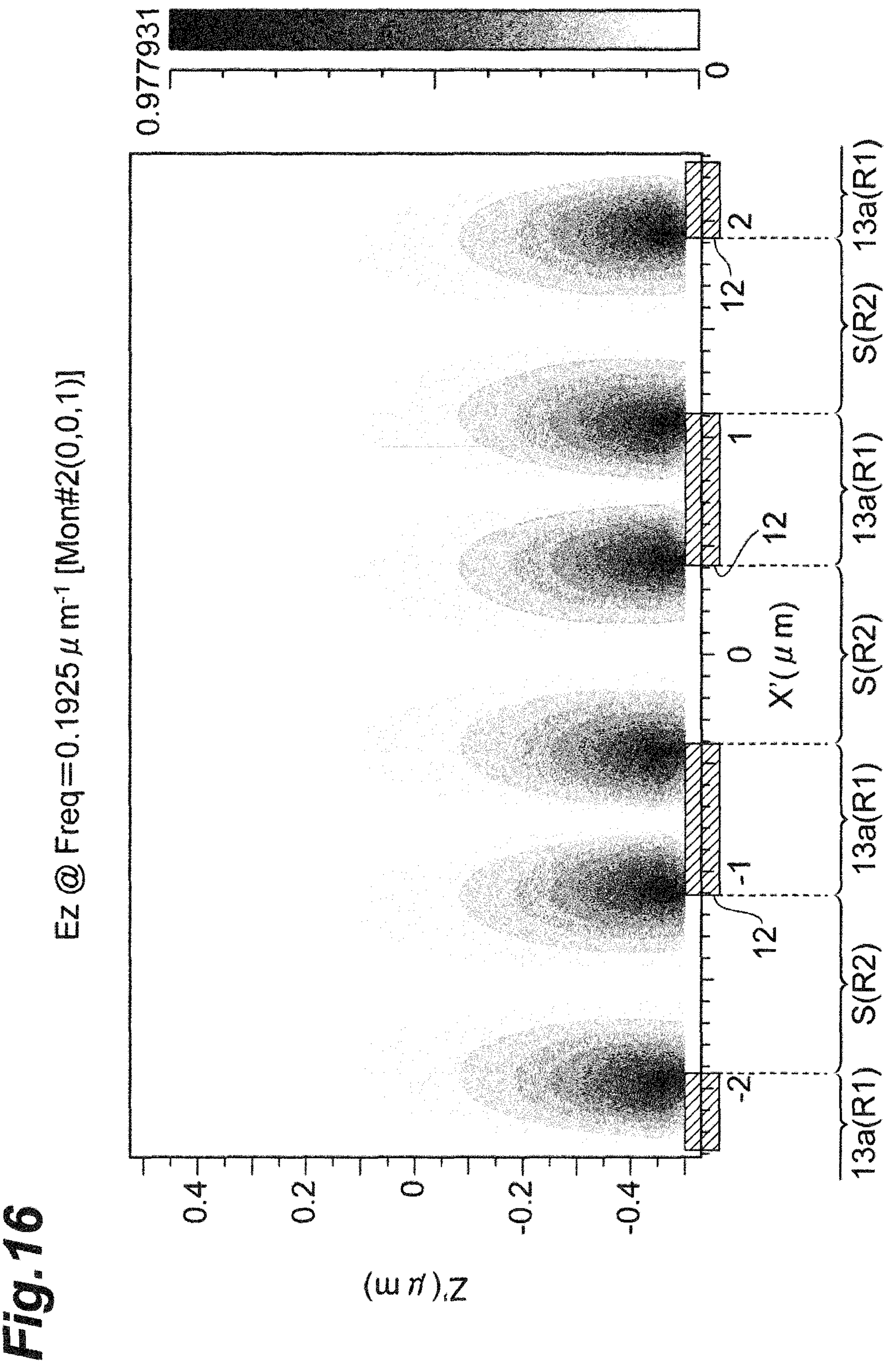
Ez @ Freq=0.1925 μm⁻¹ [Mon#2(0,0,1)]
0.977931
0
Z'(μm)
0.4
0.2
0
-0.2
-0.4
X'(μm)
-2
-1
0
1
2
12
12
12
13a(R1)
S(R2)
13a(R1)
S(R2)
13a(R1)
S(R2)
13a(R1)

Fig.17

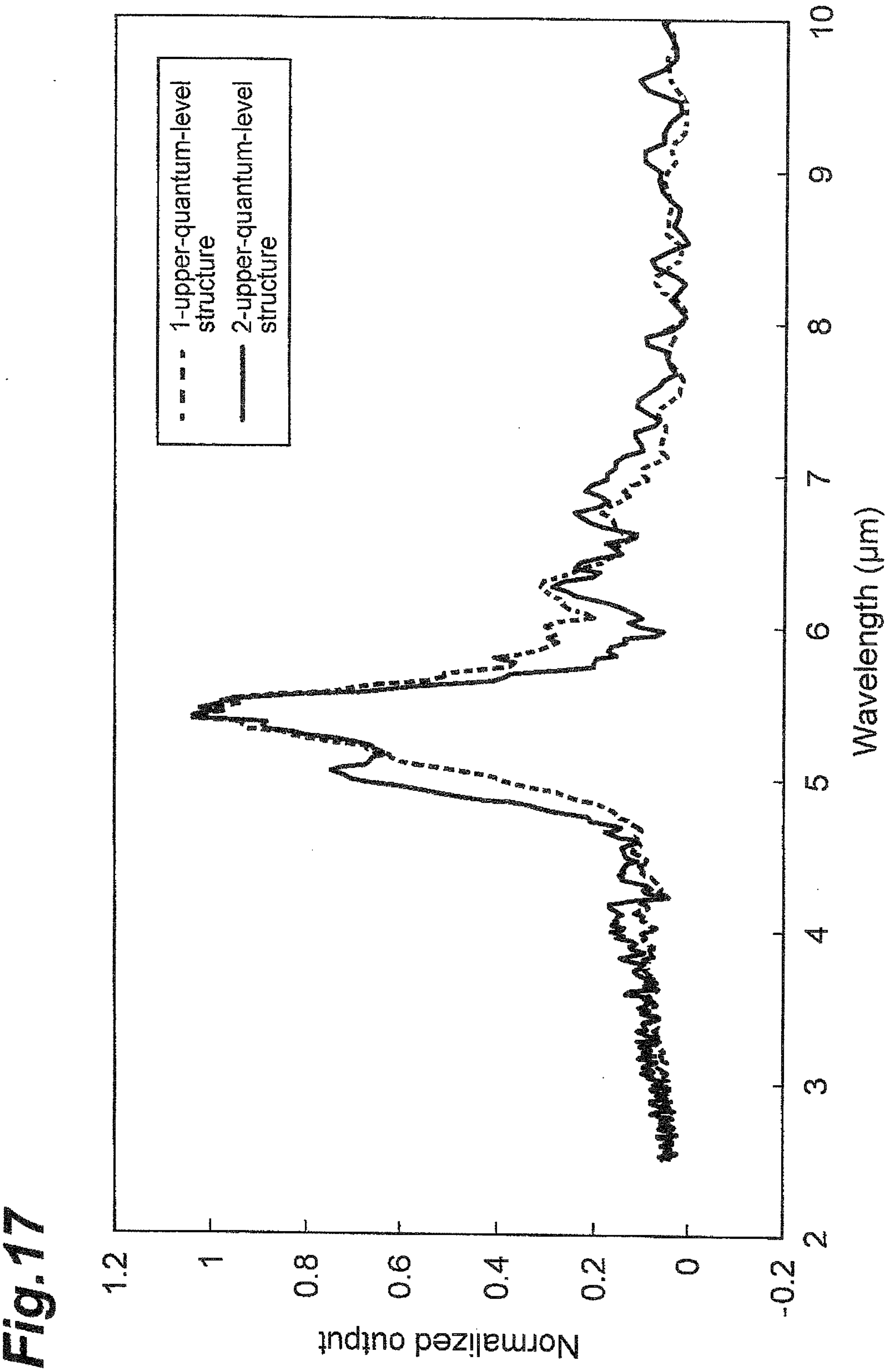
1-upper-quantum-level structure
2-upper-quantum-level structure
Normalized output
1.2
1
0.8
0.6
0.4
0.2
0
-0.2
2
3
4
5
6
7
8
9
10
Wavelength (μm)

*Fig.18*

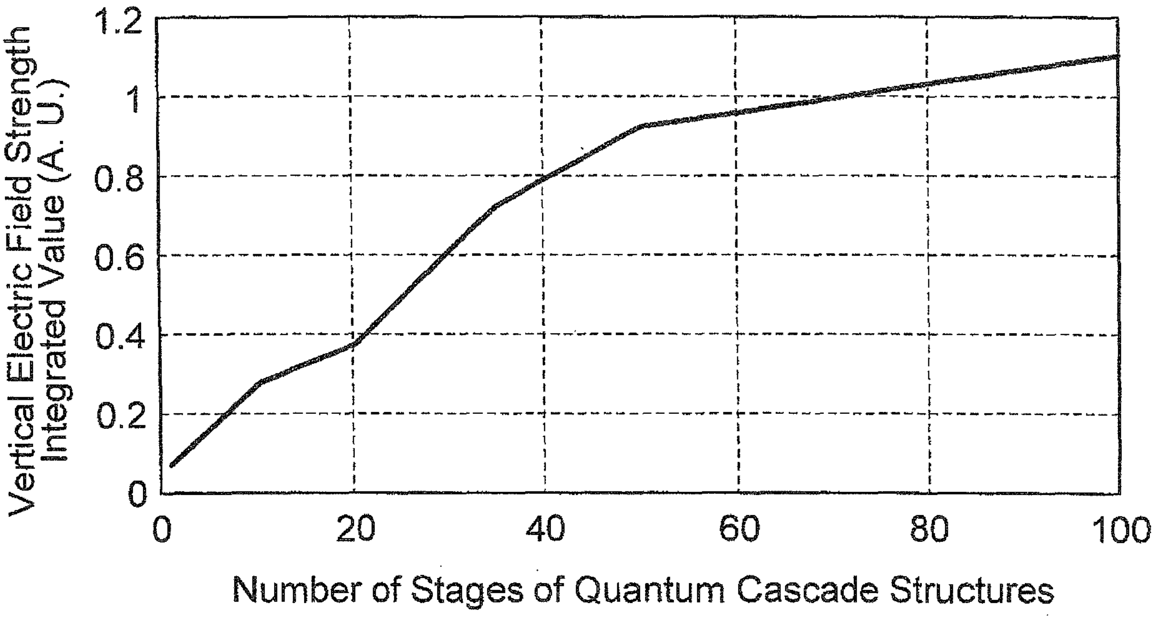
Vertical Electric Field Strength
Integrated Value (A. U.)
1.2
1
0.8
0.6
0.4
0.2
0
0
20
40
60
80
100
Number of Stages of Quantum Cascade Structures

**INTERNATIONAL SEARCH REPORT**

International application No.
PCT/JP2013/063182

A. CLASSIFICATION OF SUBJECT MATTER
*G01J1/02*(2006.01)i, *H01L31/10*(2006.01)i

According to International Patent Classification (IPC) or to both national classification and IPC

B. FIELDS SEARCHED

Minimum documentation searched (classification system followed by classification symbols)
H01L31/00-31/0392, 31/08-31/119, G01J1/02

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)
Scitation, JSTPlus(JDreamIII), JST7580(JDreamIII)

C. DOCUMENTS CONSIDERED TO BE RELEVANT

| Category* | Citation of document, with indication, where appropriate, of the relevant passages | Relevant to claim No. |
|---|---|---|
| X<br>A | JP 2012-83238 A (NEC Corp.), 26 April 2012 (26.04.2012), entire text; all drawings (Family: none) | 1-5,7-11<br>6 |
| X<br>A | S. C.Lee, S.Krishna, and S. R. Brueck, "Quantum dot infrared photodetector enhanced by surface plasma wave excitation," OPTICS EXPRESS, 2009.12.02, Vol.17, No.25, p.23160-23168. | 1-5,7-11<br>6 |
| X<br>A | Wei Wu, Alireza Bonakdar, and Hooman Mohseni, "Plasmonic enhanced quantum well infrared photodetector with high detectivity," Applied Physics Letters, 2010.04.22, vol.96, p.161107-1~3. | 1-5,7-11<br>6 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 27 May, 2013 (27.05.13) | 04 June, 2013 (04.06.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No. PCT/JP2013/063182

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 2005-159002 A (Seiko Epson Corp.), 16 June 2005 (16.06.2005), entire text; all drawings (Family: none) | 6<br>1-5,7-11 |
| Y<br>A | Shin-Yen Lin, Yau-Ren Tsai, and Si-Chen Lee, "High-performance InAs/GaAs quantum-dot infrared photodetectors with a single-sided Al0.3Ga0.7As blocking layer," Applied Physics Letters, 2001.02.16, Vol.78, No.18, p.2784-2786. | 6<br>1-5,7-11 |
| A | G. Ariyawansa et al., "Bias-selectable tricolor tunneling quantum dot infrared photodetector for atmospheric windows," Applied Physics Letters, 2008.03.19, Vol.92, p.111104-1~3. | 1-11 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000156513 A
- JP 2012069801 A
- JP 2001524757 A


### Non-patent literature cited in the description


- **W. WU et al.** Plasmonic enhanced quantum well infrared photodetector with high detectivity. *Appl. Phys. Lett.,* 2010, vol. 96, 161107
- **S. V. BANDARA et al.** Multi-band and broad-band infrared detectors based on III-V materials for spectral imaging instruments. *Infrared Phys. Technol.,* 2005, vol. 47, 15
- **KAZUUE FUJITA et al.** High-performance, homogeneous broad-gain quantum cascade lasers based on dual-upper-state design. *Appl. Phys. Lett.,* 2010, vol. 96, 241107
- **M. CHOI et al.** A terahertz metamaterial with unnaturally high refractive index. *Nature,* 2011, vol. 470, 369